# EUROPÄISCHE PATENTSCHRIFT

(11) **EP 0 875 931 B1**
(45) Veröffentlichungstag und Bekanntmachung des Hinweises auf die Patenterteilung: **14.06.2006**
(21) Anmeldenummer: 98104077.7
(22) Anmeldetag: 06.03.1998
(51) Int. Cl.: H01L 21/8238, H01L 21/20

(54) **Verfahren zur Herstellung einer CMOS-Schaltungsanordnung**
Method for the production of a CMOS circuit arrangement
Procédé de fabrication d'un dispositif de circuit CMOS

(30) Priorität: 29.04.1997 DE 19718165
(43) Veröffentlichungstag der Anmeldung: 04.11.1998
(73) Patentinhaber: Infineon Technologies AG, 81669 München (DE)
(72) Erfinder: Biebl, Markus, Dr., 86163 Augsburg (DE); Schwalke, Udo, Dr., 84431 Heldenstein (DE); Schumann, Dirk, Dr., 81479 München (DE); Schäfer, Herbert, Dr., 85635 Höhenkirchen-Siegertsbrunn (DE)
(74) Vertreter: Zimmermann & Partner

(56) Entgegenhaltungen:
- EP-A- 0 268 941
- EP-A- 0 393 215
- US-A- 5 504 031
- PATENT ABSTRACTS OF JAPAN vol. 015, no. 502 (E-1147), 18. Dezember 1991 -& JP 03 220730 A (HITACHI LTD), 27. September 1991

## Beschreibung

Bei der Miniaturisierung von Bauelementen im Hinblick auf eine erhöhte Packungsdichte werden sowohl laterale als auch vertikale Dimensionen reduziert. Bei MOS-Transistoren bedeutet dies, daß nicht nur die lateralen Abmessungen der Gateelektrode und die Kanallänge, sondern auch die Tiefe der Source-/Draingebiete reduziert wird.

In EP 0 268 941 B1 ist eine MOS-Feldeffekttransistorstruktur mit flachen Source-/Drainzonen vorgeschlagen worden. Der MOS-Feldeffekttransistor ist zwischen Feldoxidbereichen angeordnet. Zwischen der Gateelektrode des MOS-Transistors und den Feldoxidbereichen sind durch selektive Epitaxie erzeugte monokristalline, dotierte Siliziumschichten angeordnet, die als Diffusionsquellen zur Erzeugung der Source-/Draingebiete gedient haben und die Anschlußbereiche zu den darüber angeordneten Source-/Drainanschlüssen bilden.

Zur Herstellung einer CMOS-Schaltungsanordnung mit komplementären MOS-Transistoren ist in EP 0 268 941 B 1 vorgeschlagen worden, die durch selektive Epitaxie erzeugten einkristallinen dotierten Siliziumschichten unterschiedlich zu dotieren. Dieses kann entweder dadurch erfolgen, daß durch selektive Epitaxie eine undotierte Siliziumschicht sowohl im Bereich der n-Kanal- als auch im Bereich der p-Kanal-Transistoren gebildet wird. Durch Implantation unter Verwendung zweier Masken werden die Siliziumschichten anschließend je nach Transistortyp unterschiedlich dotiert. Alternativ werden zunächst n⁺-dotierte einkristalline Siliziumschichten durch selektive Epitaxie erzeugt. Dabei sind Gebiete für p-Kanal-Transistoren von einer Maske abgedeckt. Anschließend werden die Gebiete für n-Kanal-Transistoren von einer weiteren Maske abgedeckt und p⁺-dotierte n-kristalline Siliziumschichten durch selektive Epitaxie gebildet. Zur Herstellung der unterschiedlich dotierten Source-/Draingebiete sind in beiden Fällen zwei Maskenschritte erforderlich.

Der Erfindung liegt das Problem zugrunde, ein Verfahren zur Herstellung einer CMOS-Schaltungsanordnung anzugeben, bei dem der Prozeßaufwand reduziert wird.

Dieses Problem wird gelöst durch ein Verfahren gemäß Anspruch 1. Ausgestaltungen der Erfindung gehen aus den Unteransprüchen hervor.

Erfindungsgemäß wird das Problem dadurch gelöst, daß in einem Halbleitersubstrat ein n-Kanal-MOS-Transistor und ein p-Kanal-MOS-Transistor gebildet werden. Zur Bildung des p-Kanal-MOS-Transistors werden nach Erzeugung eines ersten Gatedielektrikums und einer ersten Gateelektrode, deren Flanken mit isolierenden Spacern versehen werden, durch selektive Epitaxie seitlich der ersten Gateelektrode p-dotierte, monokristalline Siliziumstrukturen gebildet. Die p-dotierten monokristallinen Siliziumstrukturen sind als Diffusionsquelle zur Bildung von Source-/Draingebieten des p-Kanal-MOS-Transistors geeignet. Die selektive Epitaxie wird dabei so durchgeführt, daß eine Siliziumabscheidung auf Oberflächen aus isolierendem Material und aus n-dotiertem Silizium unterdrückt wird. Dabei wird ausgenutzt, daß die Siliziumabscheidung bei in situ n-dotierter, selektiver Epitaxie um einen Faktor 5 bis 20 langsamer erfolgt als bei undotierter selektiver Epitaxie oder in situ p-dotierter selektiver Epitaxie. Bei der selektiven Epitaxie zur Bildung p-dotierter monokristalliner Siliziumstrukturen wirken n-dotierte Siliziumgebiete lokal als Dotierstoffquelle, an deren Oberfläche nur n-dotiertes Silizium aufwachsen kann. Durch diese Maßnahme brauchen n-dotierte Siliziumgebiete oder Gebiete aus isolierendem Material nicht mit einer separaten Maske abgedeckt zu werden, während die p-dotierten monokristallinen Siliziumstrukturen gebildet werden. Auf diese Weise wird bei der Bildung der CMOS-Schaltungsanordnung eine Maske eingespart. Das bedeutet einen reduzierten Prozeßaufwand.

Erfindungsgemäß werden nach Bildung des ersten Gatedielektrikums und der ersten Gateelektrode für den p-Kanal-MOS-Transistor und eines zweiten Gatedielektrikums und einer zweiten Gateelektrode für den n-Kanal-MOS-Transistor, deren Flanken mit isolierenden Spacern versehen werden, eine Maske gebildet, die ein aktives Gebiet für den p-Kanal-MOS-Transistor abdeckt. Durch Ionenimplantation werden anschließend n-dotierte Source-/Draingebiete für den n-Kanal-MOS-Transistor gebildet. Nach dem Entfernen der Maske wird die selektive Epitaxie zur Bildung der p-dotierten monokristallinen Siliziumstrukturen durchgeführt. Schließlich werden die Source-/Draingebiete des p-Kanal-MOS-Transistors durch Ausdiffusion aus den p-dotierten monokristallinen Siliziumstrukturen gebildet.

In einer weiteren Ausführungsform wird nach der Bildung von erstem Gatedielektrikum, erster Gateelektrode, zweitem Gatedielektrikum und zweiter Gateelektrode für den p-Kanal-MOS-Transistor bzw. den n-Kanal-MOS-Transistor und Erzeugung von isolierenden Spacern an den Flanken der ersten Gateelektrode und der zweiten Gateelektrode eine Maske gebildet, die das aktive Gebiet des p-Kanal-MOS-Transistors abdeckt. Durch selektive Epitaxie werden n-dotierte, monokristalline Siliziumstrukturen gebildet, die als Diffusionsquelle zur Bildung von Source-/Draingebieten des n-Kanal-MOS-Transistors geeignet sind. Anschließend wird die Maske entfernt und es wird die selektive Epitaxie zur Bildung der p-dotierten, monokristallinen Siliziumstrukturen durchgeführt. Da diese selektive Epitaxie zu isolierendem Material und zu n-dotiertem Silizium selektiv ist, wachsen die p-dotierten, monokristallinen Siliziumstrukturen nicht im Bereich des n-Kanal-MOS-Transistors auf. Die Source-/Draingebiete des p-Kanal-MOS-Transistors werden durch Ausdiffusion aus den p-dotierten monokristallinen Siliziumstrukturen und die Source-/Draingebiete des n-Kanal-MOS-Transistors durch Ausdiffusion aus den n-dotierten monokristallinen Siliziumstrukturen gebildet.

In beiden Ausführungsbeispielen werden, wie in der CMOS-Technologie üblich, Isolationsstrukturen gebildet, die jeweils die aktiven Gebiete für die n-Kanal-MOS-Transistoren und die p-Kanal-MOS-Transistoren definieren. Ferner werden, falls erforderlich, in bekannter Weise n-dotierte Wannen bzw. p-dotierte Wannen zur Aufnahme der p-Kanal-MOS-Transistoren bzw. n-Kanal-MOS-Transistoren hergestellt und Kanalimplantationen vorgenommen.

Die selektive Epitaxie zur Bildung der p-dotierten monokristallinen Siliziumstrukturen erfolgt vorzugsweise unter Verwendung eines H₂, HCl, SiH₂Cl₂ und B₂H₆ enthaltenden Prozeßgases im Temperaturbereich zwischen 700 und 900°C und im Druckbereich zwischen 1.3 und 930 hPa (1 und 700 Torr).

Auf diese Weise lassen sich Source-/Draingebiete mit einer Tiefe zwischen 10 und 50 nm bilden.

Es liegt im Rahmen der Erfindung, die Maske aus einer mit Hilfe photolithographischer Prozeßschritte strukturierten Maskenschicht, insbesondere aus SiO₂ zu bilden.

Im folgenden wird die Erfindung anhand der Ausführungsbeispiele, die in den Figuren dargestellt sind, näher erläutert.
- Figur 1: zeigt einen Schnitt durch ein Halbleitersubstrat mit Isolationsstrukturen und einer n-dotierten Wanne und einer p-dotierten Wanne.
- Figur 2: zeigt den Schnitt durch das Halbleitersubstrat nach Bildung von Gatedielektrikum und Gateelektroden, deren Flanken mit isolierenden Spacern versehen sind.
- Figur 3: zeigt einen Schnitt durch das Halbleitersubstrat nach Bildung einer Maske und einer Ionenimplantation zur Bildung von n-dotierten Source-/Draingebieten.
- Figur 4: zeigt den Schnitt durch das Halbleitersubstrat nach Entfernen der Maske, Bildung von p-dotierten monokristallinen Siliziumstrukturen und Bildung von p-dotierten Source-/Draingebieten durch Ausdiffusion aus den Siliziumstrukturen.
- Figur 5: zeigt einen Schnitt durch ein Halbleitersubstrat mit Isolationsstrukturen, einer n-dotierten Wanne und einer p-dotierten Wanne.
- Figur 6: zeigt den Schnitt durch das Halbleitersubstrat nach Bildung von Gatedielektrikum und Gateelektroden, deren Flanken mit isolierenden Spacern versehen sind.
- Figur 7: zeigt den Schnitt durch das Halbleitersubstrat nach einem Reoxidationsschritt.
- Figur 8: zeigt den Schnitt durch das Halbleitersubstrat nach Bildung einer Maske.
- Figur 9: zeigt den Schnitt durch das Halbleitersubstrat nach Aufwachsen von n-dotierten monokristallinen Siliziumstrukturen und nach Entfernen der Maske.
- Figur 10: zeigt den Schnitt durch das Halbleitersubstrat nach Freiätzen der Halbleiteroberfläche im Bereich der n-dotierten Wanne.
- Figur 11: zeigt das Halbleitersubstrat nach selektivem Aufwachsen von p-dotierten monokristallinen Siliziumstrukturen und nach einem Temperschritt zur Bildung von Source-/Draingebieten.

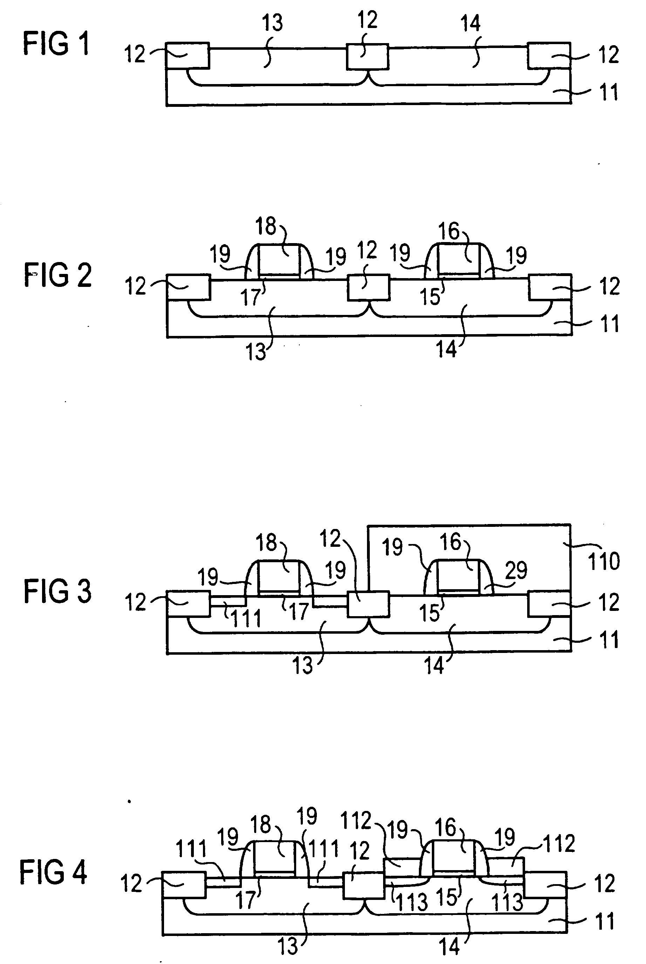

An einer Oberfläche eines Substrats, zum Beispiel einer monokristallinen Siliziumscheibe oder der monokristallinen Siliziumschicht eines SOI-Substrats, werden Isolationsstrukturen 12 gebildet (siehe Figur 1). Die Isolationsstrukturen 12 werden zum Beispiel durch lokale Oxidation in einem LOCOS-Prozeß oder durch Auffüllen isolierender Gräben in einem Shallow Trench Isolationsprozeß (STI) gebildet. Ferner werden in dem Substrat 11 eine p-dotierte Wanne 13 und eine n-dotierte Wanne 14 gebildet. Die Isolationsstrukturen 12 sind so ausgestaltet, daß sie innerhalb der p-dotierten Wanne 13 ein aktives Gebiet für einen n-Kanal-MOS-Transistor und innerhalb der n-dotierten Wanne 14 ein aktives Gebiet für einen p-Kanal-MOS-Transistor definieren.

Anschließend wird durch ganzflächiges Aufbringen einer dielektrischen Schicht und einer leitfähigen Schicht und gemeinsames Strukturieren mittels photolithographischer Prozeßschritte und anisotropem Ätzen ein erstes Gatedielektrikum 15 und eine erste Gateelektrode 16 für den p-Kanal-MOS-Transistor und ein zweites Gatedielektrikum 17 und eine zweite Gateelektrode 18 für den n-Kanal-MOS-Transistor gebildet (siehe Figur 2). Das erste Gatedielektrikum 15 und das zweite Gatedielektrikum 17 werden zum Beispiel durch thermische Oxidation aus SiO₂ in einer Schichtdicke von 5 nm gebildet. Die erste Gatelektrode 16 und die zweite Gateelektrode 18 werden zum Beispiel aus dotiertem Polysilizium und/oder Metallsilizid in einer Schichtdicke von zum Beispiel 200 nm gebildet.

Anschließend werden durch konforme Abscheidung einer isolierenden Schicht, zum Beispiel aus SiO₂ oder Si₃N₄ in einer Schichtdicke von zum Beispiel 10 bis 500 nm und durch anisotropes Rückätzen isolierende Spacer 19 an den Flanken der ersten Gateelektrode 16 und der zweiten Gateelektrode 18 gebildet.

Durch ganzflächige Abscheidung einer SiO₂-Schicht in einer Schichtdicke von zum Beispiel 100 bis 3000 nm und anschlie-ßende Strukturierung mittels photolithographischer Prozeßschritte und anisotropem Ätzen wird eine Maske 110 gebildet, die das aktive Gebiet für den p-Kanal-MOS-Transistor vollständig abdeckt. Das aktive Gebiet für den n-Kanal-MOS-Transistor läßt die Maske 110 dagegen unbedeckt (siehe Figur 3). Durch Ionenimplantation mit Arsen mit einer Energie.von zum Beispiel 5 bis 80 keV und einer Dosis von zum Beispiel 10¹⁴ bis 10²¹ cm⁻² werden anschließend Source-/Draingebiete 111 für den n-Kanal-MOS-Transistor gebildet.

Nach Entfernen der Maske 110 zum Beispiel durch Ätzen in Flußsäure und nach für eine Epitaxie erforderlichen vorbereitenden Reinigungsschritten werden durch in situ p-dotierte selektive Epitaxie p-dotierte monokristalline Siliziumstrukturen 112 an der freiliegenden Oberfläche der n-dotierten Wanne 14 gebildet. Die Prozeßparameter werden so eingestellt, daß bei der selektiven Epitaxie weder auf isolierendem Material noch auf n-dotiertem Silizium Silizium abgeschieden wird. Dazu wird ein H₂, HCl, SiH₂Cl₂, B₂H₆ enthaltendes Prozeßgas verwendet. Die selektive Epitaxie wird bei einer Temperatur im Bereich zwischen 700 und 900°C und bei einem Druck im Bereich zwischen 1.3 und 930 hPa (1 und 700 Torr) durchgeführt. In den p-dotierten monokristallinen Siliziumstrukturen 112 wird dabei eine Dotierstoffkonzentration von etwa 10²⁰ cm⁻³ eingestellt.

Nachfolgend erfolgt ein Temperprozeß, bei dem durch Ausdiffusion aus den p-dotierten monokristallinen Siliziumstrukturen 112 Source-/Draingebiete 113 für den p-Kanal-MOS-Transistor gebildet werden. Gleichzeitig wird der Dotierstoff in den Source-/Draingebieten 111 für den n-Kanal-MOS-Transistor aktiviert. Die Tiefe der Source-/Draingebiete 111 für den n-Kanal-MOS-Transistor beträgt etwa 20 bis 200 nm, die Tiefe der Source-/Draingebiete für den p-Kanal-MOS-Transistor 113 beträgt etwa 20 bis 300 nm.

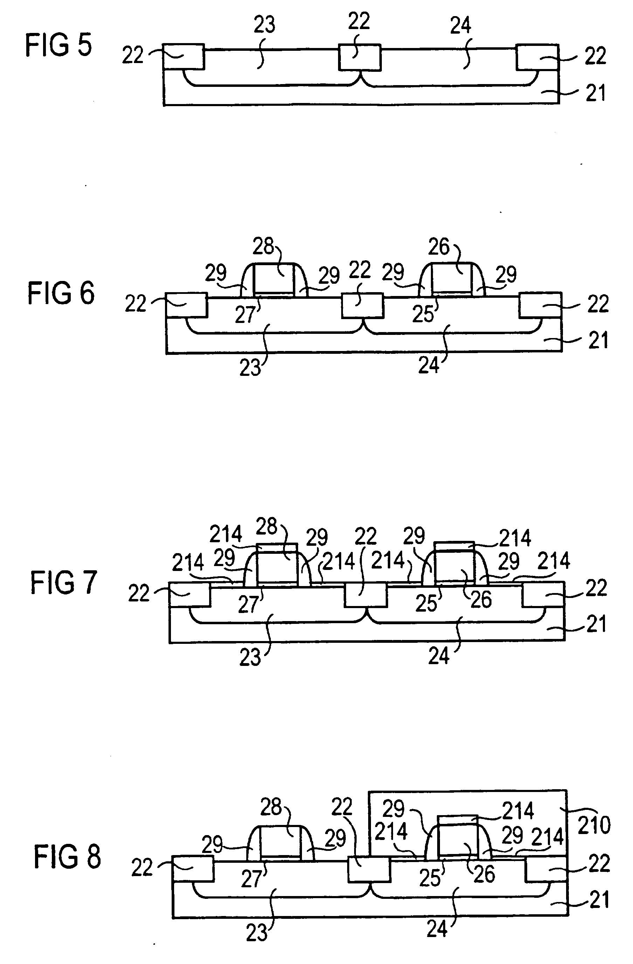

In einem weiteren Ausführungsbeispiel werden analog zum ersten Ausführungsbeispiel in einem Substrat 21 eine Isolati-onsstruktur 22, eine p-dotierte Wanne 23 und eine n-dotierte Wanne 24 gebildet. Das Substrat 21 ist wiederum zum Beispiel eine monokristalline Siliziumscheibe oder die monokristalline Siliziumschicht eines SOI-Substrats. Die Isolationsstruktur 22 wird zum Beispiel in einem LOCOS-Prozeß oder in einem STI-Prozeß gebildet. Die Isolationsstruktur 22 ist derart ausgebildet, daß sie in der p-dotierten Wanne 23 ein aktives Gebiet für eine n-Kanal-MOS-Transistor und in der n-dotierten Wanne 24 ein aktives Gebiet für einen p-Kanal-MOS-Transistor definiert (siehe Figur 5). Analog wie im ersten Ausführungsbeispiel werden ein erstes Gatedielektrikum 25 und eine erste Gateelektrode 26 für den p-Kanal-MOS-Transistor und ein zweites Gatedielektrikum 27 und eine zweite Gateelektrode 28 für den n-Kanal-MOS-Transistor gebildet. An den Flanken der Gateelektroden 26, 28 werden isolierende Spacer 29 gebildet (siehe Figur 6).

Anschließend wird eine Reoxidation bei zum Beispiel 800 bis 1100°C durchgeführt, bei der an freiliegenden Oberflächen der p-dotierten Wanne 23, der n-dotierten Wanne 24, der ersten Gateelektrode 26 und der zweiten Gateelektrode 28 eine SiO₂₋Schicht 214 in einer Schichtdicke von etwa 5 bis 100 nm gebildet wird (siehe Figur 7).

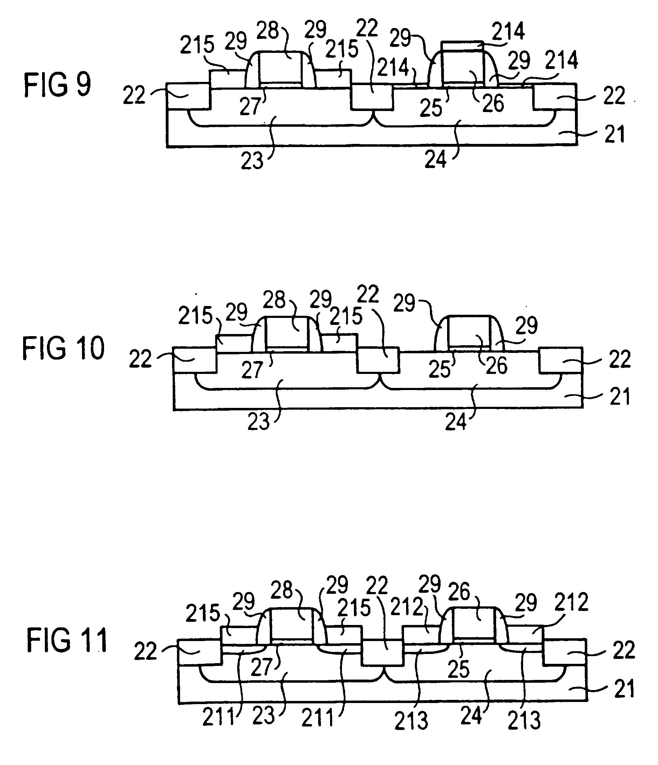

Anschließend wird durch Aufbringen einer SiO₂-Schich in einer Schichtdicke von zum Beispiel 100 bis 3000 nm und Strukturierung der SiO₂-Schicht mit Hilfe photolithographischer Verfahren und durch anisotropes Ätzen eine Maske 210 gebildet, die das aktive Gebiet für den p-Kanal-MOS-Transistor abdeckt. Das aktive Gebiet für den n-Kanal-MOS-Transistor ist dagegen von der Maske 210 unbedeckt. Bei der Strukturierung der Maske 210 wird die Oberfläche der p-dotierten Wanne 23 zwischen den Teilen der Isolationsstruktur 22 und den isolierenden Spacern 29 freigelegt (siehe Figur 8). Durch selektive Epitaxie unter Verwendung eines H₂, HCl, SiH₂Cl₂, AsH₃ enthaltenden Prozeßgases bei einer Temperatur im Bereich zwischen 700 und 900°C und einem Druck im Bereich zwischen 1.3 und 930 hPa (1 und 700 Torr) werden n-dotierte monokristalline Siliziumstrukturen 215 erzeugt. Die Epitaxie wird so geführt, daß die Siliziumabscheidung selektiv auf der freiliegenden Siliziumoberfläche der p-dotierten Wanne 23 erfolgt (siehe Figur 9). Durch Zugabe des Dotiergases AsH₃ werden die n-dotierten monokristallinen Siliziumstrukturen 215 in situ n-dotiert mit einer Dotierstoffkonzentration von ca. 10¹⁹ cm⁻³.

Anschließend wird die Maske 210 durch Ätzen zum Beispiel in Flußsäure entfernt (siehe Figur 9). Nachfolgend werden die im Bereich des aktiven Gebietes für den p-Kanal-MOS-Transistor befindlichen Teile der SiO₂-Schicht 214 durch selektives Ätzen mit HF entfernt. Die freigelegte Siliziumoberfläche der n-dotierten Wanne 14 wird für eine nachfolgende Epitaxie gereinigt (siehe Figur 10).

Durch selektive Epitaxie von in situ mit Bor dotiertem Silizium werden an der freiliegenden Oberfläche der n-dotierten Wanne 24 p-dotierte monokristalline Siliziumstrukturen 212 gebildet (siehe Figur 11). Die selektive Epitaxie wird so durchgeführt, daß Silizium weder auf der Oberfläche von isolierendem Material noch auf der Oberfläche von n-dotiertem Silizium abgeschieden wird. Dazu wird ein H₂, HCl, SiH₂Cl₂, B₂H₆ enthaltendes Prozeßgas verwendet und die Epitaxie bei einer Temperatur im Bereich zwischen 700 und 900°C und einem Druck zwischen 1.3 und 930 hPa (1 und 700 Torr) durchgeführt. In den p-dotierten monokristallinen Siliziumstrukturen 212 stellt sich durch die Zugabe des Dotiergases B₂H₆ bei der selektiven Epitaxie eine Dotierstoffkonzentration von etwa 10²⁰ cm⁻³ ein.

In einem Temperschritt zum Beispiel bei 800 bis 1100°C werden Source-/Draingebiete 211 für den n-Kanal-MOS-Transistor und Source-/Draingebiete 213 für den p-Kanal-MOS-Transistor gebildet (siehe Figur 11). Die Tiefe der Source-/Draingebiete 111 für den n-Kanal-MOS-Transistor beträgt ungefähr 20 bis 200 nm, die Tiefe der Source-/Draingebiete 213 für den p-Kanal-MOS-Transistor beträgt etwa 20 bis 300 nm.

## Patentansprüche

1. Verfahren zur Herstellung einer CMOS-Schaltungsanordnung,
- bei dem in einem Halbleitersubstrat (11) ein n-Kanal-MOS-Transistor und ein p-Kanal-MOS-Transistor gebildet werden,
- bei dem zur Bildung des p-Kanal-MOS-Transistors eine erste Gateelektrode (16) erzeugt wird, deren Flanken mit isolierenden Spacern (19) bedeckt werden,
- bei dem durch selektive Epitaxie seitlich der ersten Gateelektrode (16) p-dotierte, monokristalline Siliziumstrukturen (112) gebildet werden, die als Diffusionsquelle zur Bildung von Source-/Draingebieten (113) des p-Kanal-MOS-Transistors geeignet sind,
- bei dem die selektive Epitaxie so durchgeführt wird, daß dabei eine Siliziumabscheidung auf Oberflächen aus isolierendem Material und aus n-dotiertem Silizium unterdrückt wird.

2. Verfahren nach Anspruch 1,
- bei dem in dem Halbleitersubstrat (11) Isolationsstrukturen (12) gebildet werden, die jeweils ein aktives Gebiet für den n-Kanal-MOS-Transistor und den p-Kanal-MOS-Transistor definieren,
- bei dem ein erstes Gatedielektrikum (15) und die erste Gateelektrode (16) für den p-Kanal-MOS-Transistor und ein zweites Gatedielektrikum (17) und eine zweite Gateelektrode (18) für den n-Kanal-MOS-Transistor gebildet werden,
- bei dem an den Flanken der ersten Gateelektrode (16) und der zweiten Gateelektrode (18) isolierende Spacer (19) gebildet werden,
- bei dem eine Maske (110) gebildet wird, die das aktive Gebiet des p-Kanal-MOS-Transistors abdeckt,
- bei dem durch Ionenimplantation mit n-dotierenden Ionen Source-/Draingebiete (111) für den n-Kanal-MOS-Transistor gebildet werden,
- bei dem nach Entfernen der Maske (110) die selektive Epitaxie zur Bildung der p-dotierten monokristallinen Siliziumstruktur (112) durchgeführt wird,
- bei dem die Source-/Draingebiete (113) des p-Kanal-MOS-Transistors durch Ausdiffusion aus den p-dotierten monokristallinen Siliziumstrukturen (112) gebildet werden.

3. Verfahren nach Anspruch 1,
- bei dem in dem Halbleitersubstrat (21) Isolationsstrukturen (22) gebildet werden, die jeweils ein aktives Gebiet für den n-Kanal-MOS-Transistor und für den p-Kanal-MOS-Transistor definieren,
- bei dem ein erstes Gatedielektrikum (25) und eine erste Gateelektrode (26) für den p-Kanal-MOS-Transistor und ein zweites Gatedielektrikum (27) und eine zweite Gateelektrode (28) für den n-Kanal-MOS-Transistor gebildet werden,
- bei dem an den Flanken der ersten Gateelektrode (26) und der zweiten Gateelektrode (28) isolierende Spacer (29) gebildet werden,
- bei dem eine Maske (210) gebildet wird, die das aktive Gebiet des p-Kanal-MOS-Transistors abdeckt,
- bei dem durch selektive Epitaxie n-dotierte, monokristalline Siliziumstrukturen (215) gebildet werden, die als Diffusionsquelle zur Bildung von Source-/Draingebieten (211) des n-Kanal-MOS-Transistors geeignet sind,
- bei dem nach Entfernen der Maske (210) die selektive Epitaxie zur Bildung der p-dotierten monokristallinen Siliziumstrukturen (212) durchgeführt wird,
- bei dem die Source-/Draingebiete (213) des p-Kanal-MOS-Transistors durch Ausdiffusion aus den p-dotierten monokristallinen Siliziumstrukturen (212) und die Source-/Draingebiete (211) des n-Kanal-MOS-Transistors durch Ausdiffusion aus den n-dotierten monokristallinen Siliziumstrukturen (215) gebildet werden.

4. Verfahren nach einem der Ansprüche 1 bis 3,
- bei dem die selektive Epitaxie zur Bildung der p-dotierten monokristallinen Siliziumstrukturen (112) unter Verwendung eines H₂, HCl, SiH₂Cl₂, B₂H₆ enthaltenden Prozeßgases im Temperaturbereich zwischen 700 und 900°C und im Druckbereich zwischen 1.3 und 930 hPa durchgeführt wird.

5. Verfahren nach einem der Ansprüche 1 bis 4, bei dem die Source-/Draingebiete (111, 113) mit einer Tiefe zwischen 20 und 300 nm gebildet werden.

6. Verfahren nach einem der Ansprüche 2 bis 5,
- bei dem zur Bildung der Maske (110) eine Maskenschicht abgeschieden,
- bei dem eine Photolackmaske gebildet wird,
- bei dem die Maskenschicht unter Verwendung der Photolackmaske strukturiert wird.

7. Verfahren nach Anspruch 6,
bei dem die Maskenschicht aus SiO₂ gebildet wird.

## Claims

1. Method for the production of a CMOS circuit arrangement,
- in which an n-channel MOS transistor and a p-channel MOS transistor are formed in a semiconductor substrate (11),
- in which a first gate electrode (16), whose flanks are covered with insulating spacers (19), is produced for the purpose of forming the p-channel MOS transistor,
- in which p-doped, monocrystalline silicon structures (112) are formed by means of selective epitaxy laterally with respect to the first gate electrode (16) and are suitable as a diffusion source for forming source/drain regions (113) of the p-channel MOS transistor,
- in which the selective epitaxy is carried out in such a way that deposition of silicon on surfaces made of insulating material and made of n-doped silicon is suppressed in the process.

2. Method according to Claim 1,
- in which insulation structures (12) are formed in the semiconductor substrate (11), which insulation structures in each case define an active region for the n-channel MOS transistor and the p-channel MOS transistor,
- in which a first gate dielectric (15) and the first gate electrode (16) are formed for the p-channel MOS transistor and a second gate dielectric (17) and a second gate electrode (18) are formed for the n-channel MOS transistor,
- in which insulating spacers (19) are formed on the flanks of the first gate electrode (16) and of the second gate electrode (18),
- in which a mask (110) is formed which covers the active region of the p-channel MOS transistor,
- in which source/drain regions (111) for the n-channel MOS transistor are formed by means of ion implantation with n-doping ions,
- in which after the removal of the mask (110) the selective epitaxy for forming the p-doped, monocrystalline silicon structure (112) is carried out,
- in which the source/drain regions (113) of the p-channel MOS transistor are formed by outdiffusion from the p-doped, monocrystalline silicon structures (112).

3. Method according to Claim 1,
- in which insulation structures (22) are formed in the semiconductor substrate (21), which insulation structures in each case define an active region for the n-channel MOS transistor and the p-channel MOS transistor,
- in which a first gate dielectric (25) and a first gate electrode (26) are formed for the p-channel MOS transistor and a second gate dielectric (27) and a second gate electrode (28) are formed for the n-channel MOS transistor,
- in which insulating spacers (29) are formed on the flanks of the first gate electrode (26) and of the second gate electrode (28),
- in which a mask (210) is formed which covers the active region of the p-channel MOS transistor,
- in which n-doped, monocrystalline silicon structures (215) are formed by means of selective epitaxy and are suitable as a diffusion source for forming source/drain regions (211) of the n-channel MOS transistor,
- in which after the removal of the mask (210), the selective epitaxy for forming the p-doped, monocrystalline silicon structures (212) is carried out,
- in which the source/drain regions (213) of the p-channel MOS transistor are formed by outdiffusion from the p-doped, monocrystalline silicon structures (212), and the source/drain regions (211) of the n-channel MOS transistor are formed by outdiffusion from the n-doped, monocrystalline silicon structures (215).

4. Method according to one of Claims 1 to 3,
- in which the selective epitaxy for forming the p-doped, monocrystalline silicon structures (112) is carried out using a process gas containing H₂, HCl, SiH₂Cl₂, B₂H₆ in the temperature range between 700 and 900°C and in the pressure range between 1.3 and 930 hPa.

5. Method according to one of Claims 1 to 4,
- in which the source/drain regions (111, 113) are formed with a depth between 20 and 300 nm.

6. Method according to one of Claims 2 to 5,
- in which a mask layer is deposited for the purpose of forming the mask (110),
- in which a photoresist mask is formed,
- in which the mask layer is structured using the photoresist mask.

7. Method according to Claim 6, in which the mask layer is formed from SiO₂.

## Revendications

1. Procédé de production d'un circuit CMOS,
- dans lequel on forme dans un substrat (11) semiconducteur un transistor MOS à canal n et un transistor MOS à canal p,
- dans lequel on produit pour former le transistor MOS à canal p une première électrode (16) de grille, dont les flancs sont recouverts d'espaceurs (19) isolants,
- dans lequel on forme par épitaxie sélective latéralement à la première électrode (16) de grille des structures (112) en silicium monocristallin à dopage de type p, qui sont appropriées en tant que source de diffusion pour former des zones (113) de source-drain du transistor MOS à canal p,
- dans lequel on effectue l'épitaxie sélective en supprimant un dépôt de silicium sur des surfaces en matière isolante et en silicium à dopage du type n.

2. Procédé suivant la revendication 1,
- dans lequel on forme dans le substrat (11) semiconducteur, des structures (12) d'isolement qui définissent respectivement une zone active pour le transistor MOS à canal n et pour le transistor MOS à canal p,
- dans lequel on forme un premier diélectrique (15) de grille et la première électrode (16) de grille pour le transistor MOS à canal p et un deuxième diélectrique (17) de grille et une deuxième électrode (18) de grille pour le transistor MOS à canal n,
- dans lequel on forme sur les flancs de la première électrode (16) de grille et de la deuxième électrode (18) de grille des espaceurs (19 isolants,
- dans lequel on forme un masque (110) qui recouvre la zone active du transistor MOS à canal p,
- dans lequel on forme par implantation d'ions par des ions à dopage du type n des zones (111) de source/drain pour le transistor MOS à canal n,
- dans lequel on effectue après l'élimination du masque (110) l'épitaxie sélective pour la formation de la structure de silicium monocristallin à dopage du type p,
- dans lequel on forme les zones (113) de source/drain du transistor MOS à canal p par diffusion à partir de structures (112) de silicium monocristallin à dopage du type p.

3. Procédé suivant la revendication 1,
- dans lequel on forme dans le substrat (21) semiconducteur des structures (22) isolantes qui définissent respectivement une zone active pour le transistor MOS à canal n et pour le transistor MOS à canal p,
- dans lequel on forme un premier diélectrique (25) de grille et une première électrode (26) de grille pour le transistor MOS à canal p et un deuxième diélectrique (27) de grille et une deuxième électrode (28) de grille pour le transistor MOS à canal n,
- dans lequel on forme sur les flancs de la première électrode (26) de grille et de la deuxième électrode (28) de grille des espaceurs (29) isolants,
- dans lequel on forme un masque (210) qui recouvre la zone active du transistor MOS à canal p,
- dans lequel on forme par épitaxie sélective des structures (215) de silicium monocristallin à dopage du type n qui sont appropriées comme source de diffusion pour la formation de zones (211) de source/drain du transistor MOS à canal n,
- dans lequel après élimination du masque (210) on effectue l'épitaxie sélective pour la formation des structures (212) de silicium monocristallin à dopage du type p,
- dans lequel on forme les zones (213) de source/drain du transistor MOS à canal p par diffusion à partir des structures (212) de silicium monocristallin à dopage du type p et les zones (211) de source/drain du transistor MOS à canal n par diffusion à partir des structures (215) de silicium monocristallin à dopage du type n.

4. Procédé suivant l'une des revendications 1 à 3,
- dans lequel on effectue l'épitaxie sélective pour la formation des structures (112) de silicium monocristallin à dopage du type p en utilisant un gaz de processus contenant H₂, HCl, SiH₂Cl₂, B₂H₆ dans la plage de température comprise entre 700 et 900°C et dans la plage de pression comprise entre 1,3 et 930 hPa.

5. Procédé suivant l'une des revendications 1 à 4,
dans lequel on forme les zones (111, 113) de source/drain en leur donnant une profondeur comprise entre 20 et 300 nm.

6. Procédé suivant l'une des revendications 2 à 5,
- dans lequel on dépose pour former le masque (110) une couche de masque,
- dans lequel on forme un masque en vernis photosensible,
- dans lequel on structure la couche de masque en utilisant un masque de vernis photosensible.

7. Procédé suivant la revendication 6,
dans lequel on forme la couche de masque en SiO₂.
